## Europäisches Patentamt

## European Patent Office

## Office européen des brevets

(11) Veröffentlichungsnummer: **0 152 653**
**A2**

(12) # EUROPÄISCHE PATENTANMELDUNG

(21) Anmeldenummer: **84201938.2**

(51) Int. Cl.⁴: **G 03 F 7/02**

(22) Anmeldetag: **24.12.84**

(30) Priorität: **22.02.84 DE 3406404**

(43) Veröffentlichungstag der Anmeldung: **28.08.85**
Patentblatt 85/35

(84) Benannte Vertragsstaaten: **DE FR GB IT NL**

(71) Anmelder: **Metalon Stolberg GmbH, Cockerillstrasse 69, D-5190 Stolberg (DE)**

(72) Erfinder: **Sandig, Hartmut, Hostetstrasse 144, D-5190 Stolberg (DE)**
Erfinder: **Seel, Peter, Hostetstrasse 144, D-5190 Stolberg (DE)**
Erfinder: **Wijnands, Mathijs, Klappergasse 11, D-5100 Aachen (DE)**

(74) Vertreter: **Fischer, Ernst, Dr., Reuterweg 14, D-6000 Frankfurt am Main 1 (DE)**

(54) **Verfahren zur Herstellung lichtempfindlicher Lackschichten mit rauher Oberfläche auf Druckplatten.**

(57) Zur Erzeugung der rauhen Oberfläche lichtempfindlicher Lackschichten für Druckplatten mit einem Träger aus Aluminium werden Teilchen mit vergleichsweise kleiner Korngröße verwendet.

Um die rauhe Oberfläche der lichtempfindlichen Lackschicht in möglichst einfacher Weise herstellen zu können, werden die Teilchen auf die noch klebrige Oberfläche der Lackschicht aufgebracht und danach die Lackschicht vollständig getrocknet.

VEREINIGTE ZINKWERKE GMBH
Cockerillstr. 69

5190 Stolberg

— 1 —

22. Februar 1982
DRRO/USCHW (1372 P)

0152653

Prov. Nr. 9161 VZW

## Verfahren zur Herstellung lichtempfindlicher Lackschichten mit rauher Oberfläche auf Druckplatten

Die Erfindung betrifft ein Verfahren zur Herstellung von mittels Teilchen mit vergleichsweise kleiner Korngröße erzeugten rauhen Oberflächen lichtempfindlicher Lackschichten für Druckplatten mit einem Träger aus band-, streifen- oder plattenförmigem Werkstoff, vorzugsweise Aluminium.

Beim Kopieren von Vorlagen auf lichtempfindlichen Druckplatten ist es erforderlich, daß die Vorlagen in innigem Kontakt mit der lichtempfindlichen Lackschicht stehen, um ein dimensionsgetreues Kopieren zu ermöglichen. Dazu ist es notwendig, daß die zwischen der lichtempfindlichen Lackschicht und der Kopiervorlage befindliche Luft restlos beseitigt wird. Das geschieht üblicherweise durch Evakuieren der Kopiereinrichtung bzw. des Kopierrahmens. Allerdings ist das Evakuieren in Abhängigkeit von der Oberflächengestalt der lichtempfindlichen Lackschicht und der Kopiervorlage mit einem mehr oder weniger großen Zeitaufwand verbunden. Abgesehen davon, daß in den Fällen, in denen die Oberfläche der lichtempfindlichen Lackschicht und der Vorlage vollkommen eben sind, sich Lufteinschlüsse durch übliche Evakuierungsmaßnahmen nicht entfernen lassen, können beim Evakuieren in der lichtempfindlichen Lackschicht gegebenenfalls noch vorhandene Restlösungsmittel verdampfen und das Vakuum beeinträchtigen. Darüber hinaus besteht die Gefahr, daß, ausgelöst durch den Belichtungsvorgang beim Kopieren, Gase entstehen, die während des Kopierens eine partielle Abhebung von lichtempfindlicher Lackschicht und Kopiervorlage verursachen, mit der Folge, daß, bedingt durch die Beugung der Lichtstrahlen, unterschiedliche Abweichungen in der Übertragungstreue entstehen.

Um diesen Nachteilen abzuhelfen, sind bereits zahlreiche Vorschläge unterbreitet worden. So ist beispielsweise vorgesehen, auf die Oberfläche der lichtempfindlichen Lackschicht und/oder der Kopiervorlage ein feinkörniges Pulver aufzustreuen, dessen Teilchen als kleine Abstandhalter zwischen der ebenen lichtempfindlichen Lackschicht und der Kopiervorlage wirken. Dadurch ist es möglich, daß sowohl die Luft von der Oberfläche der lichtempfindlichen Lackschicht als auch und die während des Kopiervorganges gegebenenfalls entstehenden Gase relative schnell beseitigt werden können. Dieses Verfahren hat allerdings den Nachteil, daß der Kopierrahmen, wenigstens von Zeit zu Zeit, wie auch die Kopiervorlage nach jedem Gebrauch von den daran haftenden Pulverteilchen gereinigt werden müssen.

Vorgesehen sind auch Druckplatten, deren lichtempfindliche Lackschicht eine mittels Pigmenten aufgerauhte Deckschicht aufweist. Zum Einbringen der Pigmente ist ein zusätzlicher Arbeitsvorgang notwendig. Nachteilig ist ferner der relativ große Abstand zwischen der lichtempfindlichen Lackschicht und der Kopiervorlage.

In der EP-PS 21 428 ist ferner eine lichtempfindliche Druckplatte mit einem Schichtträger aus Aluminium und einer positiv arbeitenden lichtempfindlichen Schicht mit rauher Oberfläche und einem Gehalt an feinteiligen Partikeln vorgesehen, bei der die kleinste Abmessung der Partikel mindestens so groß ist wie die Dicke der lichtempfindlichen Schicht, der mittlere Durchmesser der Partikel zwischen 1 und 20 /um liegt und die lichtempfindliche Schicht 0,02 bis 2,0 Gew. % Partikel enthält. Das Einbringen von Partikeln mit einer Korngröße, deren kleinster Durchmesser mindestens der Schichtdicke entspricht, ist mit fertigungstechnischen Schwierigkeiten verbunden; denn solche Partikel neigen zum Absetzen und müssen daher durch geeignete Maßnahmen, z.B. durch mechanische Rührer in dem Fotolack in Schwebe gehalten werden. Dadurch kann es in nachteiliger Weise zu Gaseinschlüssen im Lack kommen, die beim anschließenden Auftragen des Fotolacks auf den Träger zu Schwierigkeiten führen können.

Es ist die Aufgabe der vorliegenden Erfindung, das eingangs beschriebene Verfahren so auszubilden, daß mit möglichst geringem Aufwand auf der lichtempfindlichen Lackschicht eine rauhe Oberfläche herstellbar ist, wobei die Korngröße der verwendeten Teilchen unabhängig von der Dicke der lichtempfindlichen Lackschicht sein soll.

Die Lösung dieser Aufgabe besteht darin, daß auf die noch nicht vollständig getrocknete, klebrige Oberfläche der lichtempfindlichen Lackschicht eine aus Teilchen kleiner Korngröße bestehende Schicht in feiner Verteilung aufgetragen und anschließend die lichtempfindliche Lackschicht getrocknet wird, so daß die Teilchen fest mit der lichtempfindlichen Lackschicht verklebt sind.

Die dabei verwendeten Teilchen besitzen nach einem weiteren Erfindungsmerkmal eine Korngröße von 0,5 bis 2 /um und sind gemäß einer besonderen Ausgestaltung des erfindungsgemäßen Verfahrens so verteilt, daß 10 bis 500 Teilchen/cm$^2$ liegen.

Als Teilchen kommen alle organischen und anorganischen
Stoffe wie Silicagel, $Al_2O_3$, $TiO_2$ oder dergl. in Betracht, vorzugsweise jedoch solche, die lichtdurchlässig
sind und deren Brechungsindex ähnlich oder gleich demjenigen der lichtempfindlichen Lackschicht ist.

Im Rahmen der Weiterbildung des erfindungsgemäßen Verfahrens werden die Teilchen durch einen Luftstrom aufgetragen, dessen Teilchenbelastung von der gewünschten Verteilung (Teilchenzahl/$cm^2$) auf der Oberfläche der lichtempfindlichen Lackschicht abhängt. Bei der kontinuierlichen Herstellung der lichtempfindlichen Lackschicht ist
die Teilchenbelastung des Luftstromes zusätzlich noch der
Geschwindigkeit des zu beschichtenden Bandes oder Streifens abhängig.

Ferner besteht die Möglichkeit die Teilchen beispielsweise
durch ein vibratorgetriebenes Verteilersystem oder mittels
eines Siebes, innerhalb einer Kammer, die das Band, der
Streifen oder die Platte durchläuft und die mit einem geringen Unterdruck abgesaugt wird, auf die lichtempfindliche Lackschicht aufzutragen.

In manchen Fällen kann es auch angebracht sein, wenn die
Teilchen auf elektrostatischem Weg auf die lichtempfindliche Lackschicht aufgebracht wird.

Zur Herstellung der lichtempfindlichen Druckplatte wird
beispielsweise auf den aus einer Aluminiumplatte bestehenden in bekannter Weise aufgerauhten und anodisierten Träger eine aus einem herkömmlichen Fotolack bestehende
lichtempfindliche Lackschicht von 2 /um Dicke aufgebracht und auf deren noch klebrige Oberfläche mittels
eines Luftstroms Silicagel mit einer mittleren Korngröße
von 6 /um und einer Verteilung von 150 Teilchen/$cm^2$

0152653

aufgetragen. Anschließend wird die lichtempfindliche Lackschicht bei ca. 90 °C etwa 4 Minuten lang bis zum Erreichen des endgültigen Trocknungsgrades getrocknet.

PATENTANSPRÜCHE

1. Verfahren zur Herstellung von mittels Teilchen mit vergleichsweise kleiner Korngröße erzeugten rauhen Oberfläche lichtempfindlicher Lackschichten für Druckplatten mit einem Träger aus band-, streifen- oder plattenförmigem Werkstoff, vorzugsweise Aluminium, dadurch gekennzeichnet, daß auf die noch nicht vollständig getrocknete, klebrige Oberfläche der lichtempfindlichen
   Lackschicht eine aus Teilchen mit kleiner Korngröße bestehende Schicht in feiner Verteilung aufgetragen wird
   und danach die lichtempfindliche Lackschicht getrocknet
   wird.

2. Verfahren nach Anspruch 1, dadurch gekennzeichnet, daß
   die Korngröße der Teilchen 0,5 bis 2,0 /um beträgt.

3. Verfahren nach den Ansprüchen 1 und 2, dadurch gekennzeichnet, daß die Verteilung der Teilchen
   10 bis 500 Teilchen/cm$^2$ beträgt.

4. Verfahren nach den Ansprüchen 1 bis 3, dadurch gekennzeichnet, daß die Teilchen aus organischem und anorganischem Material bestehen.

5. Verfahren nach Anspruch 4, dadurch gekennzeichnet, daß
   die Teilchen lichtdurchlässig sind und ihr Brechungsindex gleich oder ähnlich demjenigen der lichtempfindlichen Lackschicht ist.

6. Verfahren nach den Ansprüchen 1 bis 5, dadurch gekennzeichnet, daß die Teilchen mit Hilfe eines Luftstromes,
   dessen Teilchenbelastung von der gewünschten Verteilung

- 7 - 0152653

(Teilchenzahl/cm$^2$) auf der Oberfläche der lichtempfindlichen Lackschicht abhängt, aufgetragen werden.

7. Verfahren nach den Ansprüchen 1 bis 5, <u>dadurch gekenn-
zeichnet</u>, daß die Teilchen durch ein vibratorgetriebenes Verteilersystem oder mittels eines Siebes innerhalb einer Kammer, die das mit der lichtempfindlichen
Lackschicht versehene Band, Streifen oder Platte durchläuft und die mit einem geringen Unterdruck abgesaugt
wird, auf die Lackschicht aufgetragen werden.

8. Verfahren nach den Ansprüchen 1 bis 5, <u>dadurch gekenn-
zeichnet</u>, daß die Teilchen auf elektrostatischem Weg
auf die lichtempfindliche Lackschicht aufgebracht werden.